(19) Europäisches Patentamt

European Patent Office

Office européen des brevets

(11) **EP 1 569 340 A1**

(12) **EUROPEAN PATENT APPLICATION**

(43) Date of publication:
**31.08.2005   Bulletin 2005/35**

(51) Int Cl.⁷: **H03K 4/00**

(21) Application number: **04002825.0**

(22) Date of filing: **09.02.2004**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK**<br><br>(71) Applicant: **Ford Global Technologies, LLC**<br>**Dearborn, MI 48126 (US)** | (72) Inventor: **Tuveson, Tryggve**<br>**434 92 Vallda (SE)**<br><br>(74) Representative: **Widahl, Jenny Marie**<br>**Volvo Car Corporation,**<br>**Intellectual Property Department 91030 PVD4:1**<br>**405 31 Göteborg (SE)** |

(54) **Pulse shaper**

(57)    This invention relates to a method for reducing the amplitude of higher harmonic frequency components of an electric pulse (9) comprising at least a first and a second signal level (10, 11), the pulse (9) being arranged to be transmitted through an electric wire in a vehicle, the method comprising the step of providing at least one of a trailing edge (13) or a leading edge (12) of said electric pulse (9) with an essentially smooth transition (12') between said first and second signal level (10, 11).

*Fig. 1*

EP 1 569 340 A1

**Description**

**Field of the invention**

This invention relates to a method for reducing the amplitude of higher harmomc frequency components of an electric pulse comprising at least a first and a second signal level, the pulse being arranged to be transmitted through an electric wire in a vehicle.

**Background of the invention**

Pulsed electric waveforms are currently commonly used in electrical applications, for example for power distribution or for transmitting information within a vehicle. For instance, for controlling power in a DC-motor, pulse width modulation (PWM) systems result in lower power losses in the power electronics than linear systems. In communication protocols, like LIN, the pulses are necessary since the combinations of pulses are directly translatable to the content of the message to be transmitted.

A special issue with vehicles is that space is very limited, and thus the distance from a pulsed signal source to adjacent items (hereinafter referred to as "victims") which may be sensitive to disturbances is short. Hence, there may be a good coupling between the signal source and a victim. For instance, it is often very difficult to keep harness far separated from any receiver antennas within the vehicle, and even a small radio frequency interfering signal may be harmful, if the coupling between the signal source and the victim is good.

Traditionally, essentially perfect square waves have been used, both for transmitting information and for power distribution within vehicles. However, essentially perfect square waves has the disadvantage of containing high harmonic frequency components, with an amplitude that may disturb or destroy the function of receivers and other electrical equipment in the vicinity, either by radiation or by conduction. This problem is especially troublesome in vehicles, wherein many electrical applications and devices often are contained in a small volume.

For power applications, it is desirable to have short rise and fall times in the transitions to keep the power losses in the driving power stage low. From this point of view, the essentially perfect square waves are ideal, but the disadvantage is that the amplitude of higher harmonics is large. As indicated above, the harmonics may be harmful to equipment in the vicinity, including the generating equipment, either by conduction or radiation.

One way to solve this problem has been to reduce the above-mentioned higher harmonic frequencies by using a pulse with transitions between the signal levels that give a trapezoidal curve shape. Hence, by increasing the rise and fall times of the pulse, the amplitude of the harmonics is decreased, solving some of the problems indicated above. However, such a pulse is subject to larger power losses, which is disadvantageous.

For communication purposes, power losses are in general neglectable. However, it is more important that the transitions are well defined in time to avoid interpretation errors. The transitions shall therefore be as short as possible. However, the use of essentially perfect square waves suffer from the same drawbacks indicated above.

In view of the above, there is a need for an alternative solution to the above mentioned issues with the prior art.

**Summary of the invention**

Hence an object of this invention is to achieve an alternative way to reduce the amplitude of higher harmonic frequencies when using pulsed signals within vehicles, while still avoiding an unsatisfying increase of the rise and fall time for the transition.

Yet an object of this invention is to achieve a universal solution which may be used in various applications.

A further object of this invention is to achieve a method overcoming the problems stated above.

The above and other objects are at least in part achieved by a method for reducing the amplitude of higher harmonic frequency components of an electric pulse comprising at least a first and a second signal level, the pulse being transmitted through an electric wire in a vehicle, the method comprising the step of providing at least one of a trailing edge or a leading edge of said electric pulse with an essentially smooth transition between said first and second signal level. By providing a smooth transition between the signal levels, it is possible to decrease the content of high frequency components of the pulse, at the same time during which the pulse is in an undefined state may be decreased.

According to a first preferred embodiment of this invention, the step of providing at least one of a trailing edge or a leading edge of said electric pulse with an essentially smooth transition comprises imparting a sinusoidal waveform to the edge of the electric pulse. This may for instance be achieved by using a freerunning sinewave oscillator that uses the next feasible part of the wave to shape the pulse. Another alternative is to use a lookup table, from which different transition shapes, including a sinusoidal shape, may be stored. By using a sinusoidal shape on the transition between the signal levels, the amplitudes of the high frequency components in the pulse will be significantly lower, compared to a trapezoidal transition. Moreover, the power dissipation is reduced. Also, due to a higher gradient in the undefined area between two binary signal levels, , the undefined pulse level time, for example representing the transition from 30-70% of the signal amplitude in communication applications, may be decreased, which reduces the risk of interpretation errors.

According to a second preferred embodiment of this invention, the step of providing at least one of a trailing edge or a leading edge of said electric pulse with an essentially smooth transition comprises imparting a waveform defined by means of MacLaurin series expansion to the edge of the electric pulse. This embodiment exhibits essentially the same advantages as the sinusoidal shape described above.

Other alternative embodiments for the inventive smooth transition are to use exponential charging and discharging of a capacitor (i.e. RC-behavior) in order to generate the smooth transition. Alternatively, a ramp may be used to charge and discharge a capacitor in order to generate the smooth transition. This results in a quadratic output and is a simple realization of this invention. As yet an alternative embodiment, a piecewise linear approximation may be used to generate said essentially smooth transition.

It shall be noted that the term "electric pulse" as used herein shall be construed as one of a current pulse or a voltage pulse.

**Brief description of the drawings**

This invention will hereinafter be described in closer detail by means of presently preferred embodiments thereof, with reference to the accompanying drawings.

Fig 1 is a basic block diagram disclosing one realization of the inventive method, intended for use in a vehicle.

Fig 2a is a schematic drawing depicting an essentially square waveform as used in the prior art and illustrates a single pulse in a pulse train.

Fig 2b is a schematic drawing of a leading edge transition between two signal levels, comparing a prior art trapezoidal transition and a smooth transition according to this invention.

Fig 3a is a chart disclosing the frequency content of a sinusoidal transition according to this invention.

Fig 3b is a chart disclosing the frequency content of a trapezoidal transition according to prior art.

Fig 4a discloses a simple transistor stage, for use when comparing power losses.

Fig 4b is a power dissipation chart for the transistor stage in fig 4a, comparing the power loss for a trapezoidal and a sinusoidal transition, respectively.

Fig 5a depicts an example of a transition waveform using a MacLaurin expansion, as compared to a sinusoidal transition.

Fig 5b depicts an example of a transition waveform using a $x^2$ output, as compared to a cosinusoidal transition.

Fig 5c depicts an example of a transition waveform using an exponential approximation, as compared to a cosinusoidal transition.

**Description of preferred embodiments of the invention**

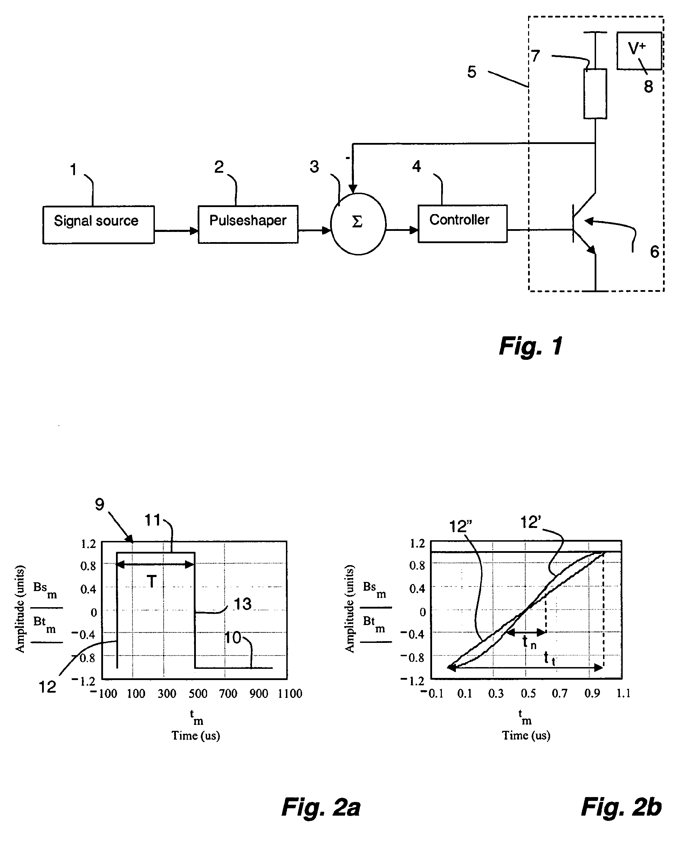

Referring to fig 1, it discloses a basic block diagram over an arrangement that may be used to implement the method according to this invention. However, it shall be noted that this invention is not primarily related to an apparatus, but is in fact independent of any specific realizations. This specific example arrangement comprises a signal source 1, arranged to generate a signal pulse or a sequence of signal pulses, a pulse shaper 2, used to shape or generate the pulse, in particular its leading or trailing edge, in accordance with this invention as will be described below, a summarizer 3, a controller 4, and a transistor stage 5, essentially comprising a transistor 6, a resistive load 7 and a voltage source 8. Together, the parts 3 to 8 described above constitute a basic closed loop controller. The output at the resistive load 7 and the input from the pulse shaper 2 are subtracted in a summarizer 3. The difference is fed into the controller 4 with an application specific transfer function. The controller output is connected to the driving stage, here a bipolar transistor 6.

The signal source 1 in this case is arranged to generate an essentially square wave pulse 9 (or a sequence of essentially square wave pulses as the case may be), as illustrated by fig 2a, and as is previously used in the prior art. This pulse 9 is essentially defined by a first signal level 10, a second signal level 11, a leading edge 12 and a trailing edge 13. Thereafter, according to the invention, the generated pulse 9 is transmitted as an input pulse to the pulse shaper 2, in which the input pulse is used to synchronize the shaping of the pulse, according to this invention. Specifically, the leading edge 12 of the pulse 9 is used to trig the pulse shaper 2 to generate an output pulse, starting with a leading edge having a shape determined by the pulse shaper, and correspondingly, the trailing edge 13 of the pulse 9 is used to trig the pulse shaper 2 to end the output pulse with a trailing edge having a shape determined by the pulse shaper. In accordance with this invention, the pulse shaper is arranged to provide the output pulse with a smooth leading and/or trailing edge. An example of a smooth transition leading edge 12' shape is disclosed in fig 2b, together with a prior art trapezoidal leading edge shape 12". The edge 12' shape disclosed in fig 2b is in this case a sinusoidal shape, providing a smooth transition between the first and second signal level 10, 11, in this case essentially corresponding to the signal levels 10, 11 of the input pulse 9. The remaining part of the pulse looks similar to the one disclosed in fig 2a, and therefore, similar notification is used below. The amplitude and length of the input pulse to the pulse shaper determines the amplitude and length of the output pulse. However, it shall be noted that the pulse shaper may be arranged to alter for instance the amplitude of the output pulse in relation to the input pulse. It shall also be noted in this example that the transition time $t_t$ of the output pulse (see fig 2b for an example) is small in relation to the duration of the output pulse T (for a corresponding example, see fig 2a). In the present example, the duration of the output pulse T is 500 µs and the transition time 1 µs, for the full transition. Also it shall be noted that although the description herein is mainly directed to the leading edge transition, the same reasoning is equally applicable to the trailing edge transition.

The pulse shaper 2 may be implemented in several different ways, depending on the specific applications. Some examples are mentioned below:

- Use of a lookup table with clocked output to a D/A-converter. The transition shape can be freely selected from one or more transition shapes stored in the lookup table.
- Use of a freerunning sinewave oscillator that uses next feasable part of the wave. It will give a small, random delay of the output.
- Use of a ramp to charge and discharge a capacitor. It will give an $x^2$ output and is a simple realization.
- Use MacLaurin series expansion with sufficient number of terms. This may be done with analogue multipliers.
- Use exponential charging and discharging of a capacitor.
- Use piecewise linear approximation, to achieve an essentially smooth transition.

Examples of definitions of the pulse shapes described above are given below. In the below definitions, the two signal levels 10, 11 are assumed to be -1 and 1. The functions given below are valid for the leading edge. Similar functions may be defined for the trailing edge. Note also that the selections of different definition intervals are made for clarity. It is obvious that simple variable substitutions will give the desired interval.

The sinusoidal transition is defined by

$$U(x) = -\cos(x) \qquad 0 \leq x \leq \pi$$

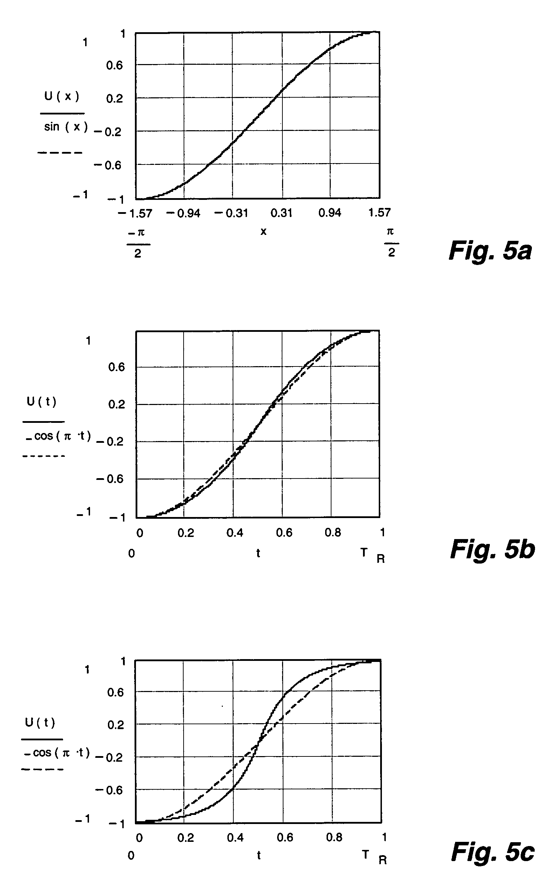

The MacLaurin expansion with 3 terms (see fig 5a) is defined by

$$U(x) = x - \frac{x^3}{3!} + \frac{x^5}{5!} \qquad -\frac{\pi}{2} \leq x \leq \frac{\pi}{2}$$

The use of the above MacLaurin expansion theoretically gives an amplitude error of less than 0.5 %, making this alternative attractive. By using fewer or more terms, the simplicity of the realization or the accuracy may be improved, respectively.

The integration of a ramp (see fig 5b) is defined by

$$U(t) := \begin{vmatrix} -1 + \left(\frac{2}{T_R}\right)^2 \cdot t^2 & \text{if } 0 \leq t \leq \frac{T_R}{2} \\ \\ 1 - \left(\frac{2}{T_R}\right)^2 \cdot (T_R - t)^2 & \text{if } \frac{T_R}{2} < t \leq T_R \end{vmatrix}$$

Here, $T_R$ is the transition time for a trapezoidal transition.

Similarly, the exponential charging and discharging of a capacitor (see fig 5c) is defined by

$$U(t) := \begin{vmatrix} -1 + e^{K\left(\frac{2}{T_R}t - 1\right)} & \text{if } 0 \le t \le \frac{T_R}{2} \\ \\ 1 - e^{-K \cdot \left(\frac{2}{T_R}t - 1\right)} & \text{if } \frac{T_R}{2} < t \le T_R \end{vmatrix}$$

K in combination with the constant -1 in the exponent gives the required start and final value for the charging in order to avoid an infinite time. For example, by selecting K to 4, the charging starts and ends with an amplitude step < 1%.

Hereinafter, the function behind the invention will be described as compared to the application of a trapezoidal pulse shape according to the prior art and as indicated in fig 2a.

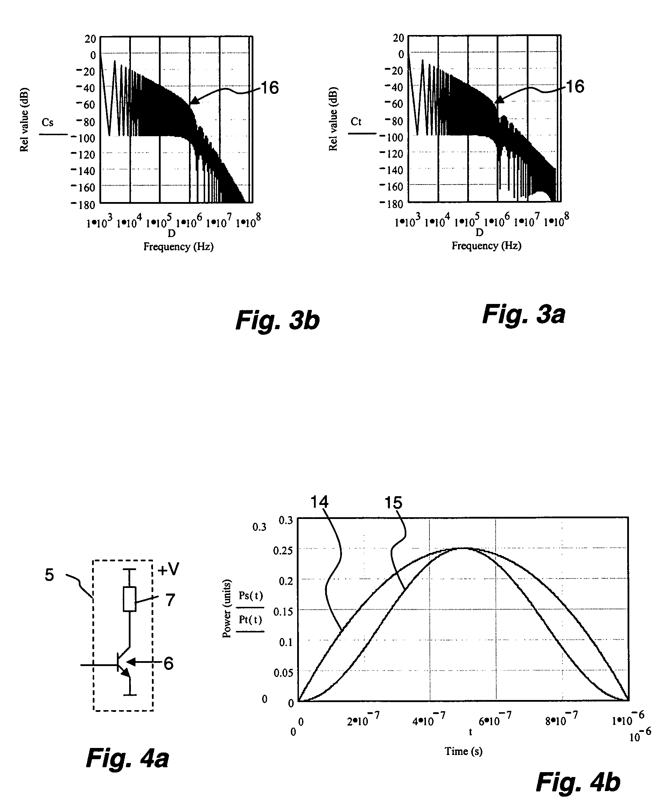

The frequency content of the trapezoidal and sinusoidal, smooth transitions of fig 2b is disclosed in fig 3a and 3b, respectively. The frequency content is determined with amplitude factors in a Fourier series expansion. It shall be noted that the lowest frequency component is determined by a pulse repetition frequency (PRF) which in the case of fig 2a and 2b is 1 kHz. The breakpoint 16 of the frequency envelope is determined by the transition time, and may be calculated as $1/\pi * t_t$ (=318 kHz for t=1 $\mu$s) for a trapezoidal transition and approximately equal for a sinusoidal transition. In both cases (fig 3a and fig 3b), the first part of the graph has a slope of -20 dB/decade. However, the second part of the envelope has a slope of -40 dB/decade for the trapezoidal transition (fig 3a) and -60 dB/decade for the sinusoidal transition (fig 3b). Thus, by using a smooth transition, in this case a sinusoidal transition, a significantly higher reduction of the amplitude of high frequency components may be achieved, which is advantageous in many applications.

The effects of the invention on the power dissipation will hereinafter be illustrated with reference to fig 4, which illustrates a basic example, using a simple transistor stage 5 with a resistive load 7. This example is used to illustrate a comparison of the power dissipation for the prior art trapezoidal transition and the inventive smooth transition (see fig 2b). In this comparison only losses during the transition part of the pulse is regarded. The losses during the constant signal levels 10, 11 (for instance an on and an off state) are considered to be equal in the two cases. The result of the comparison is disclosed in fig 4b in which the power dissipation for a trapezoidal transition (14) and a sinusoidal transition (15) as a function of time. It may be shown that the power dissipation Pt is proportional to $t*(1-t/t_t)$ for a trapezoidal transition and to $\sin^2(\pi*t/t_t)$ for a sinusoidal, where $t_t$ is the transition time. The power losses are in every moment less (or equal) for a sinusoidal transition 15 than for a trapezoidal transition 14. Integration over the transition time $t_t$ shows that the total energy loss is 25 % lower for a sinusoidal transition in accordance with this invention.

As is indicated in fig 2b, the total rise time $t_t$ for corresponding trapezoidal and sinusoidal transitions is the same. However, in binary electronics, signal levels are defined if they are above one level or below another level. There is an interval between these two signal levels where the signal is undefined. This undefined pulse level time interval $t_n$, as indicated in fig 2b, is typically 30-70 % of the supply voltage. The narrower this interval is or the shorter time the signal level is in the interval, the better the signal quality is in the respect that the logic value inside a component represents the signal level at the input. With the assumed interval of uncertainty (30-70 %) the sinus transition, with reference to the example in fig 2b, is undefined between 0.37 and 0.63 $\mu$s, that is 0.26 $\mu$s. For the trapezoidal transition the corresponding time is from 0.3 to 0.7 $\mu$s, that is 0.4 $\mu$s. Hence, the time during which the signal is undefined is around 35 % shorter for a sinusoidal transition, and hence the signal quality increases with the present invention, as the risk for interpretation errors decreases. It may be proven that the above statement is correct for essentially any smooth transition, since the presence of smooth transition points implies a sharper gradient for the smooth transition in the "undefined", or central area described above, as compared to the prior art trapezoidal transition.

Hence, by applying a smooth transition, such as a sinusoidal transition, to an electric pulse to be used within a vehicle, gives a better performance, compared to the prior art trapezoidal transition, in at least three aspects:

- High frequency components get significantly lower amplitude.
- The power dissipation is significantly lower.
- The transition between binary states is significantly improved.

As stated above, the inventive principle is especially suitable for use in a vehicle or the like, due to the environment. In a vehicle, like a car or a lorry, space is very limited and thus the distance from a source to a victim can be very short. This gives a good coupling. In a car, many "ticks" in the radio receiver are generated by windscreen wipers, break lights, direction indicators and so forth. If, instead of a sharp pulse as generated by a switch, relay or MOSFET, a smooth transition is used, the annoying sound or tick will be eliminated, in accordance with the advantages stated above.

Also, Pulse Width Modulation (PWM) can be used for controlling power, flow, pressure or speed within a vehicle. This will give a continuous noise, caused by harmonics in the same frequency as the tuned station. With a smooth transition the radio frequency interference will be much less. Signal and status exchange take place in multiplexed bus system in modem vehicles. The signals are pulses in some cases transported in a single wire with a return ground common to other loads or in the chassis. This gives radio frequency interference harmful to receiver systems. If the pulses are smooth, the disturbance will be much lower in the RF range. Also, in vehicles, the chassis is mostly used as return conductor, i.e. no physically parallel wire with opposite current direction is present to a wire. As a consequence, magnetic fields are generated. Health effect guidelines show that the higher harmonics should be attenuated, and also this aspect is achieved with this invention.

Another advantage with this invention lies within the field of acoustics, since there will be an impact on the generation of audible as well as non-audible (for humans) noise generation. This is due to the fact that low frequency noise, which may be observed as sound by humans or animals, and which is caused by mechanical oscillations, induced by electrical powering, may be avoided by this invention.

It shall be noted that the description above is given in exemplary purpose only, and that many embodiments are possible for a man skilled in the art without departing from the scope of this invention. This is especially important regarding the shape of the smooth transition of the pulse. Although the preferred shape is a sinusoidal shape or a shape based on a MacLaurin expansion, many other shapes are possible, achieving some or all of the advantages indicated above. One basic example of such a transition is a ramp with rounded transition points, in order to avoid any sharp transitions, thus reducing the amplitude of the high frequency components of the pulse. Also, other expansion series may be used. It shall also be noted that, preferably each trailing or leading edge in a pulse sequence is preferably shaped according to this invention.

List of Nomenclature

1. Signal source
2. Pulse shaper
3. Summarizer
4. Controller
5. Transistor stage
6. Transistor
7. Resistive load
8. Voltage source
9. Electric pulse
10. First signal level
11. Second signal level
12. Leading edge transition
12'. Sinusoidal transition
12". Trapezoidal transition
13. Trailing edge transition
14. Trapezoidal transition power dissipation curve
15. Sinusoidal transition power dissipation curve
16. Break point
T. Pulse duration
$t_t$. Transition time
$t_n$. Undefined pulse level time

**Claims**

1. A method for reducing the amplitude of higher harmonic frequency components of an electric pulse (9) comprising at least a first and a second signal level (10, 11), the pulse (9) being arranged to be transmitted through an electric wire in a vehicle, the method comprising the following step:

   providing at least one of a trailing edge (13) or a leading edge (12) of said electric pulse (9) with an essentially smooth transition (12') between said first and second signal level (10, 11).

2. A method according to claim 1, wherein the step of providing at least one of a trailing edge or a leading edge (10, 11) of said electric pulse (9) with an essentially smooth transition (12') comprises imparting a sinusoidal waveform to the edge of the electric pulse (9).

3. A method according to claim 1, wherein the step of providing at least one of a trailing edge or a leading edge (10, 11) of said electric pulse (9) with an essentially smooth transition (12') comprises imparting a waveform defined by means of MacLaurin series expansion to the edge of the electric pulse (9).

4. A method according to claim 1, wherein the step of providing at least one of a trailing edge or a leading edge (10, 11) of said electric pulse (9) with an essentially smooth transition (12') comprises imparting at least one of a quadratic, exponential or a piecewise linear approximation waveform to the edge of the electric pulse (9).

5. A method according to any one of the preceding claims, wherein said electric pulse (9) is one of a current pulse or a voltage pulse.

6. Use of the method according to any of the preceding claims for an electrical pulse used in a vehicle communication protocol.

7. Use of the method according to any of the preceding claims for an electrical pulse in a vehicle power application.

8. A vehicle comprising an electrical arrangement for generating an electric pulse according to the method as defined by any one of the claims 1-5.

**Fig. 1**

**Fig. 2a**              **Fig. 2b**

**Fig. 3b**

**Fig. 3a**

**Fig. 4a**

**Fig. 4b**

Fig. 5a

Fig. 5b

Fig. 5c

**European Patent Office**

Application Number

EP 04 00 2825

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 390 356 A (NOKIA MOBILE PHONES LTD) 3 October 1990 (1990-10-03) * page 2, line 1 - page 4, line 7 * ----- | 1-8 | H03K4/00 |
| A | SU 1 077 045 A (AGEEV RAJMOND V; VORONTSOV EVGENIJ B; BONDARCHUK EDUARD G; NESTEROV VL) 29 February 1984 (1984-02-29) * the whole document * ----- | 1-8 | |
| A | FI 88 566 B (NOKIA MOBILE PHONES LTD) 15 February 1993 (1993-02-15) * the whole document * ----- | 1-8 | |
| A | SU 566 335 A (ROZENBERG YURIJ B; SHEJKINA TAMARA V; MIRONOV ALEKSANDR M) 25 July 1977 (1977-07-25) * the whole document * ----- | 1-8 | |
| | | | **TECHNICAL FIELDS SEARCHED (Int.Cl.7)** H03K |

The present search report has been drawn up for all claims

| Place of search | Date of completion of the search | Examiner |
|---|---|---|
| Munich | 4 May 2004 | Villafuerte Abrego |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 04 00 2825

This annex lists the patent family members relating to the patent documents cited in the above-mentioned European search report.
The members are as contained in the European Patent Office EDP file on
The European Patent Office is in no way liable for these particulars which are merely given for the purpose of information.

04-05-2004

| Patent document cited in search report | | Publication date | Patent family member(s) | | Publication date |
|---|---|---|---|---|---|
| EP 0390356 | A | 03-10-1990 | FI | 891512 A | 30-09-1990 |
| | | | AT | 133016 T | 15-01-1996 |
| | | | DE | 69024688 D1 | 22-02-1996 |
| | | | DE | 69024688 T2 | 04-07-1996 |
| | | | EP | 0390356 A2 | 03-10-1990 |
| | | | ES | 2083426 T3 | 16-04-1996 |
| | | | FI | 88566 B | 15-02-1993 |
| | | | US | 5118965 A | 02-06-1992 |
| SU 1077045 | A | 29-02-1984 | SU | 1077045 A1 | 29-02-1984 |
| FI 88566 | B | 15-02-1993 | FI | 891512 A | 30-09-1990 |
| | | | AT | 133016 T | 15-01-1996 |
| | | | DE | 69024688 D1 | 22-02-1996 |
| | | | DE | 69024688 T2 | 04-07-1996 |
| | | | EP | 0390356 A2 | 03-10-1990 |
| | | | ES | 2083426 T3 | 16-04-1996 |
| | | | US | 5118965 A | 02-06-1992 |
| SU 566335 | A | 25-07-1977 | SU | 566335 A1 | 25-07-1977 |

EPO FORM P0459

For more details about this annex : see Official Journal of the European Patent Office, No. 12/82